# EUROPÄISCHE PATENTSCHRIFT

(11) **EP 1 322 947 B1**
(45) Veröffentlichungstag und Bekanntmachung des Hinweises auf die Patenterteilung: **12.12.2007**
(21) Anmeldenummer: 01967040.5
(22) Anmeldetag: 03.09.2001
(51) Int. Cl.: G01N 27/447, B01L 3/00

(54) **VERFAHREN ZUM HERSTELLEN EINER 3-D-MIKRODURCHFLUSSZELLE UND 3-D-MIKRODURCHFLUSSZELLE**
METHOD FOR PRODUCING A 3-D MICRO FLOW CELL AND A 3-D MICRO FLOW CELL
PROCEDE POUR LA PRODUCTION D'UNE MICROCUVE A CIRCULATION TRIDIMENSIONNELLE ET MICROCUVE A CIRCULATION TRIDIMENSIONNELLE

(30) Priorität: 07.09.2000 DE 10044333; 03.02.2001 DE 10104957
(43) Veröffentlichungstag der Anmeldung: 02.07.2003
(73) Patentinhaber: GeSIM Gesellschaft für Silizium-Mikrosysteme mbH, 01454 Grosserkmannsdorf (DE)
(72) Erfinder: HOWITZ, Steffen, 01159 Dresden (DE); FUHR, Günther, 10187 Berlin (DE)
(74) Vertreter: Hudler, Frank
(86) Internationale Anmeldenummer: PCT/DE2001/003324
(87) Internationale Veröffentlichungsnummer: WO 2002/021115

(56) Entgegenhaltungen:
- WO-A-00/17630
- DE-A- 3 739 333
- US-A- 4 908 112
- US-A- 5 141 868
- US-A- 5 520 787
- US-A- 6 045 676
- MUELLER T ET AL: "3-D MICROELECTRODE SYSTEM FOR HANDLING AND CAGING SINGLE CELLS AND PARTICLES" BIOSENSORS & BIOELECTRONICS, ELSEVIER SCIENCE PUBLISHERS, BARKING, GB, Bd. 14, 15. März 1999 (1999-03-15), Seiten 247-256, XP000912020 ISSN: 0956-5663
- JONES H L ET AL: "Hydrodynamic ECL (electrogenerated chemiluminescence)" IBM TECHNICAL DISCLOSURE BULLETIN, OCT. 1979, USA, Bd. 22, Nr. 5, Seite 2065 XP002186348 ISSN: 0018-8689

## Beschreibung

Die Erfindung betrifft ein Verfahren zum Herstellen einer 3-D-Mikrodurchflusszelle, bestehend aus einem unteren und einem oberen Substrat, zwischen denen ein Strömungskanal angeordnet ist, den eine mit Außenkontakten verbundene Elektrodenstruktur durchdringt, wobei wenigstens eines der Substrate zunächst mit einer Leitbahn- und Elektrodenstruktur und an den Enden des Strömungskanales mit Durchkontaktierungen zum Anschluss eines Flüssigkeitszu- und -ablaufes versehen wird. Die Erfindung betrifft ferner eine mit dem Verfahren hergestellte 3-D-Mikrodurchflusszelle.

Derartige 3-D-Mikrodurchflusszellen werden beispielsweise als Zellmanipulatoren für die Handhabung und optische Analyse dielektrischer biologischer Partikel, insbesondere von Zellen und/oder Bakterien bzw. Viren, verwendet. Zu diesem Zweck sind die Mikrodurchflusszellen mit einem Strömungskanal ausgestattet, an dessen Enden ein oder mehrere Flüssigkeitszu- und - abläufe vorgesehen sind. Diese Flüssigkeitszu- und -abläufe werden beispielsweise durch sich senkrecht zum Strömungskanal erstreckende Durchkontaktierungen hergestellt. Die Höhe des Flüssigkeitskanales liegt in der Regel im Bereich von wenigen Mikrometern, wobei der Strömungskanal oben und unten durch Glassubstrate und/oder Siliziumsubstrate und seitlich durch entsprechende Kanalwandungen begrenzt wird. Um einzelne Zellen an einem vorgegebenen Ort innerhalb des Flüssigkeitskanales "freischwebend" fixieren zu können, befinden sich im Flüssigkeitskanal Elektroden, die beim Anlegen einer elektrischen Spannung ein elektrisches Feld erzeugen. Die elektrostatisch fixierte Zelle kann dann durch eine geeignete Beleuchtung beleuchtet und mittels eines Mikroskopes beobachtet werden.

Um derartige dreidimensionale Strukturen realisieren zu können, sind verschiedene Technologien allgemein bekannt geworden. So kann z. B. ein Glassubstrat einseitig nasschemisch geätzt werden, um einen Strömungskanal in diesem auszubilden und nachfolgend mittels Diffusionsschweißen mit einem zweiten Glassubstrat als Deckelement verbunden werden. Die für das Handling von Zellen oder biologischen Partikeln erforderlichen Elektroden werden vorher auf das erste und/oder zweite Glassubstrat mittels bekannter Verfahren der Fotolithografie aufgebracht und das zweite Glassubstrat nachfolgend Face-down auf das untere Glassubstrat montiert.

Die Technologie des Diffusionsschweißens ist allerdings relativ teuer und die Möglichkeiten der in der Regel isotropen Glasstrukturierung sind begrenzt. Ein weiterer Nachteil ist darin zu sehen, dass nur relativ grobe Elektrodenstrukturen auf die strukturierten Glasoberflächen aufgebracht werden können. Um ein exaktes Handling einzelner Zellen oder biologischer Partikel realisieren zu können, ist jedoch eine äußerst präzise geometrische Ausbildung der Elektroden erforderlich, um diese Partikel elektrostatisch am gewünschten Ort berührungslos manipulieren und festhalten zu können.

Eine andere Technologie wird von Müller/Gradl/Howitz/Shirley/Schnelle/Fuhr in der Zeitschrift "BIOSENSORS & ELECTRONICS", Heft 14 (1999), Seite 247 bis 256 beschrieben. Hierbei handelt es sich um die Anwendung der rein manuellen Epoxydharzklebetechnik, wobei zunächst ein Polymer-Spacer auf eine Glasoberfläche prozessiert wird, die vorher mit Platinelektroden und elektrischen Leitbahnen versehen worden ist. Anschließend wird das Glassubstrat mit einem Kunstharz, z.B. Epoxydharz, als Klebstoff außerhalb der Polymerstruktur bestrichen und danach darauf ein zweites Glas, welches ebenfalls mit Elektroden versehen ist, positioniert und der Verbund nachfolgend verpresst. Dieser Montageschritt wird üblicherweise mit einen sogenannten Die-Bonder (Chip-Bonder) ausgeführt.

Schwierigkeiten sind hier darin zu sehen, dass es problematisch ist, Mikrodurchflusszellen herzustellen, die immer exakt gleiche geometrische Abmessungen aufweisen und bei denen mit Sicherheit während des Montageprozesses kein Klebstoff in den Strömungskanal eindringt, der diesen teilweise verengen würde. Die Effizienz dieses Schrittes ist daher äußerst mangelhaft und für eine Massenproduktion nicht geeignet.

Weiterhin ist eine sogenannte Underfiller-Technik bekannt geworden, bei der ein Polymer-1 (Dicklack) auf das mit Elektroden versehene Glassubstrat aufgeschleudert wird, wobei die Dicke des aufgeschleuderten Polymers durch die Höhe des vorgesehenen Kanales vorgegeben wird. Aus diesem Polymer wird dann das Positiv-Kanalsystem strukturiert, d. h. der übrige Dicklack wird während dieser Fotostrukturierung vollständig entfernt. Anschließend wird dann das zweite Glassubstrat zum ersten Glassubstrat justiert und aufgepresst. Diese auf diese Weise gewonnene 3-D-Anordnung wird durch seitliches Einströmen eines kriechfähigen Klebers (Underfiller), einem Polymer-2, fixiert, wonach das Kanalsystem im Polymer-1 mit einem Lösungsmittel wieder ausgewaschen wird. Dabei darf das Lösungsmittel das Polymer-2 nicht angreifen. Besonders nachteilig ist hier, dass auf diesem Wege im Kanal keine inneren Strömungselemente herstellbar sind, weil diese vom Polymer-2 nicht erreicht werden können. Außerdem ist diese Technik äußerst zeitaufwändig und hinsichtlich der Strukturauflösung begrenzt.

Der Erfindung liegt nunmehr die Aufgabe zugrunde, ein Verfahren zum Herstellen einer 3-D-Mikrodurchflusszelle aufzuzeigen, welches kostengünstig realisiert werden kann und mit dem insbesondere gleichbleibende geometrische Parameter realisiert werden können. Der Erfindung liegt ferner die Aufgabe zugrunde, eine 3-D-Mikrodurchflusszelle zu schaffen, die mit dem erfindungsgemäßen Verfahren kostengünstig hergestellt werden kann.

Die der Erfindung zugrunde liegende Aufgabe wird bei einem Verfahren zum Herstellen einer 3-D-Mikrodurchflusszelle, bestehend aus einem unteren und einem oberen Substrat, zwischen denen ein Strömungskanal angeordnet ist, den eine mit Außenkontakten verbundene Elektrodenstruktur durchdringt, wobei wenigstens eines der Substrate zunächst mit einer Leitbahn- und Elektrodenstruktur und an den Enden des Strömungskanales mit Durchkontaktierungen zum Anschluss von Flüssigkeitszu- und - abläufen versehen wird, dadurch gelöst, dass wenigstens auf dem unterem Substrat den Strömungskanal beidseits desselben definierende Spacer-I sowie zusätzliche Abstandshalter aus einem im wesentlichen nichtkompressiblen Material oder härtbaren Material vorgegebener Höhe aufgebracht werden, die nach dem Aufbringen mit dem unteren bzw. oberen Substrat irreversibel fest verbunden werden, dass außerhalb des Strömungskanales ein pastöser Klebstoff als Spacer-II gleichmäßiger Dicke aufgetragen wird und dass anschließend das obere Substrat auf dem unteren Substrat positioniert und unter Kraft- und Wärmeeinwirkung mit diesem verbunden wird, wobei gleichzeitig der Strömungskanal abgedichtet wird.

Dieses einfach zu realisierende Verfahren gewährleistet einer- seits eine äußerste Präzision der geometrischen Abmessungen des Strömungskanales und andererseits eine vollständige und einfache Abdichtung desselben, ohne dass die Gefahr besteht, dass Klebstoffmengen in den Strömungskanal eindringen, die diesen verengen könnten.

In einer ersten Fortführung der Erfindung wird der Spacer-II unmittelbar neben dem Spacer-I, diesen parallel umfassend, aufgetragen, wobei die Dicke des Spacers-II vor der Montage größer ist, als die Höhe des Spacers-I.

In einer besonderen Variante der Erfindung wird der Spacer-I mit einer längs desselben verlaufenden Grube versehen und der pastöse Spacer-II in diese Grube dispenst oder gedruckt. Durch diese Variante wird das Eindringen von Kleber (Spacer-II) in den Strömungskanal beim Aufsetzen des oberen Substrates auf des untere Substrat und beim nachfolgenden Verpressen sicher verhindert. Darüberhinaus lassen sich problemlos auch größere Spacerhöhen realisieren.

Die flache Grube kann mit den üblichen Mitteln der Fotolithografie hergestellt werden.

Für die Herstellung der Spacer-I und der Abstandshalter bestehen unterschiedliche Möglichkeiten. So können die Spacer-I und die Abstandshalter mittels Siebdruck, oder Dispensieren auf das untere Substrat aufgebracht und anschließend gehärtet werden, wobei das Härten beispielsweise durch Wärmeeinwirkung oder durch Licht- bzw. UV-Bestrahlung vorgenommen werden kann.

Eine andere Möglichkeit besteht darin, die Spacer-I und die Abstandshalter auf dem unteren Substrat mittels fotolitografischer Verfahren herzustellen und anschließend durch Tempern zu härten. Vorzugsweise werden hierzu der Spacer-I und die Abstandshalter aus einem fotostrukturierbaren Resist, hergestellt, wobei die Restdicke die Höhe des Strömungskanales definiert. Fotolithografische Verfahren ermöglichen gegenüber dem Siebdruck eine geringere Kantenrauhigkeit und damit eine größere Präzision, so dass feinere Strukturen hergestellt werden können.

Eine weitere Möglichkeit besteht darin, den Spacer-I und die Abstandshalter aus einer vorstrukturierten, wenigstens einseitig klebenden Metall- oder Polymerfolie herzustellen und auf das untere Substrat aufzukleben.

Für die Befestigung des oberen Substrates auf dem unteren Substrat, d. h. zum Herstellen der 3-D-Struktur, wird vorzugsweise ein Klebstoff als Spacer-II auf der Basis von Epoxydharz oder Silikonkautschuk verwendet. Die Herstellung der Verbindung des oberen mit dem unteren Substrat kann unter Einwirkung von Druck und Wärme und/oder Licht- bzw. UV-Bestrahlung erfolgen.

Die der Erfindung zugrunde liegende Aufgabenstellung wird ferner durch eine 3-D-Mikrodurchflusszelle gelöst, die aus einem unteren und einem oberen Substrat besteht, wobei zwischen den Substraten ein mit fluidischen Durchkontaktierungen versehener Strömungskanal angeordnet ist, den ein mit Außenkontakten verbundenes Elektrodensystem durchdringt und die dadurch gekennzeichnet ist, dass wenigstens auf dem unteren Substrat den Strömungskanal definierende Spacer-I sowie zusätzliche. Abstandshalter aus einem im wesentlichen nicht kompressiblen Material oder härtbaren Material vorgegebener Höhe angeordnet sind, die mit dem unteren bzw. oberen Substrat irreversibel fest verbunden sind, und dass das obere Substrat mit dem unteren Substrat den Strömungskanal dicht verschließend, mittels einer pastösen, härtbaren Klebstoffschicht, einen Spacer-II bildend, verbunden ist.

In einer ersten Ausgestaltung der Erfindung erstreckt sich der Spacer-II beidseits außerhalb des Strömungskanales auf der Außenseite des Spacers-I, diesen parallel umfassend.

In einer zweiten Ausgestaltung der Erfindung ist in der Oberfläche des Spacers-I eine flache Grube zur Aufnahme eines pastösen Spacers-II eingearbeitet, wodurch während des Montagevorganges des oberen Substrates auf dem unteren Substrat das Eindringen von Kleber in den Strömungskanal sicher verhindert wird.

Die Dicke der Spacer-I und der Abstandshalter muss gleich groß sein und sollte zwischen 10 µm und 1 mm in Abhängigkeit von der vorgesehenen Höhe des Strömungskanales liegen.

In Fortführung der Erfindung kann wenigstens eines der beiden Glassubstrate eine Dicke von 250 µm ... 1000 µm aufweisen und das andere 500 µm ... 1000 µm dick sein. So erhält der Verbund eine ausreichende mechanische Stabilität und ist zugleich für den Einsatz hochauflösender Mikroskopie geeignet.

Das obere Substrat kann auch aus einer Kunststoff-Folie, beispielsweise einer Polymerfolie, mit einer Dicke von 170 µm bis 200 µm, bestehen.

Eine weitere Ausgestaltung der Erfindung ist dadurch gekennzeichnet, dass der Bereich des Strömungskanales wenigstens im Wellenlängenbereich von 250 nm bis 450 nm optisch transparent ist. Dies kann einfach durch Auswahl geeigneter Materialien für das untere und das obere Substrat realisiert werden.

Die Erfindung ist in einer weiteren besonderen Ausgestaltung dadurch gekennzeichnet, dass wenigstens das obere oder das untere Substrat jeweils metallische Mikroelektroden aufweist, die in einem vorgegebenen dreidimensionalen geometrischen Bezug zueinander stehen und dass das obere Substrat Face-down auf dem unteren Substrat montiert ist. Die Mikroelektroden des oberen Substrates sind mit Kontaktpads versehen und mit den Außenkontakten auf dem unteren Substrat mittels Leitkleber, Leitgummi oder Lötpads elektrisch verbunden.

Die Mikroelektroden können aus einem Dünnfilmsystem, aus Platin, Gold, Tantal, Titan, Aluminium oder einem leitfähigen ITO (Indium-Tin-Oxid) bestehen.

In einer besonderen Ausgestaltung der Erfindung ist das Elektroden- und Anschlusssystem auf dem oberen und dem unteren Substrat mittels eines anorganischen Isolatormateriales ganzflächig isoliert, wobei das Isolatormaterial im inneren des Strömungskanales, auf den Kontaktpads sowie auf den Kontaktsupports ausgespart ist, um eine ausreichende elektrische Kontaktierung an diesen Stellen zu ermöglichen.

Um eine durch das Polymer des Spacers-I - der den Strömungskanal bildet - bei Lichtanregung verursachte Eigenfluoreszenz während der optisch-mikroskopischen Detektion auszublenden, ist auf der Außenseite des oberen Substrates eine zumindest lichtundurchlässige Blende in der Weise angebracht, dass der Randbereich des Strömungskanales abgedeckt, jedoch dessen zentraler Bereich freigehalten ist. Der besondere Vorteil einer solchen Blende ist, dass eine fluoreszenzbasierte Detektion an biologischen Zellen im Strömungskanal erfolgen kann, ohne dass die dabei gleichzeitig veranlasste Fluoreszenz der den Kanal begrenzenden Materialien einen störenden Einfluss ausüben würde.

Die Blende kann vorteilhaft auch als Abschirmung von innen und außen für elektromagnetische,und bioelektrische Wellen ausgebildet sein, wodurch sicher verhindert wird, dass eine gegebenenfalls einwirkende elektromagnetische Strahlung einen negativen Einfluss auf die Zellen selbst und damit das Detektionsergebnis ausüben kann.

Im einfachsten Fall besteht die Blende aus Metall, wobei diese auch aus einem fotolithografisch strukturierbaren Dünnfilm, z.B. aus Cu oder A1, bestehen kann.

Dieser Dünnfilm sollte zweckmäßigerweise ablösbar sein, so dass im Bedarfsfall der Strömungskanal in gesamter Breite optisch untersucht werden kann.

Um die Ausbildung eines Kleberfilmes auf der Innenseite des Strömungskanales möglichst zu verhindern, ist in einer besonderen Fortführung der Erfindung der Spacer-I in seiner Kontaktfläche mit einer Nut oder mit einer anderweitig längs desselben verlaufenden Vertiefung zur Aufnahme von Klebstoff während des Montageprozesses versehen.

In besonderen Fällen kann es wünschenswert sein, dass das obere Substrat lösbar mit dem unteren Substrat verbunden ist. Für diesen Fall ist eine besondere Variante der Erfindung dadurch gekennzeichnet, dass der Spacer-I aus einem Fotoresist und der Spacer-II aus einem gedruckten Silikonkautschuk bestehen und nach dem Ausvulkanisieren das obere und das untere Substrat kraftschlüssig, fluidisch dicht und reversibel miteinander verbunden sind. Dadurch lässt sich diese 3-D-Mikrodurchflusszelle nach Gebrauch wieder öffnen und bei Bedarf sterilisieren.

Eine weitere besondere Variante der Erfindung ist dadurch gekennzeichnet, dass der fotolithografisch auf dem unteren Substrat hergestellte Spacer-I eine Breite aufweist, die im wesentlichen der Parallelanordnung von Spacer-I und Spacer-II entspricht und dass das obere Substrat durch Adhäsionskraft auf dem unteren Substrat befestigt ist. Diese Variante der Erfindung ist allerdings nur für solche Fälle geeignet, in denen das obere Substrat keine Elektrodenstruktur enthält.

Die Erfindung soll nachfolgend an einem Ausführungsbeispiel näher erläutert werden. In den zugehörigen Zeichnungen zeigen:
- Fig. 1: eine schematische Draufsicht auf eine 3-D-Mikrodurchflusszelle;
- Fig. 2: eine Sequenz der Herstellung des unteren Substrates der 3-D-Mikrodurchflusszelle;
- Fig. 3: die Montage-Sequenz zur Fertigstellung der 3-D-Mikrodurchflusszelle;
- Fig. 4: eine Schnittdarstellung der 3-D-Mikrodurchflusszelle entsprechend Fig. 3 als Glas-Glas-Modul;
- Fig. 5: eine Schnittdarstellung einer 3-D-Mikrodurchflusszelle mit Flip-Chip-Kontaktierung; und
- Fig. 6: eine mit einer Cu-Blende versehene 3-D-Mikrodurchflusszelle.

Aus der Zeichnungsfigur 1 ist eine erfindungsgemäße 3-D-Mikrodurchflusszelle ersichtlich, die aus einem unteren Substrat 1 aus Glas mit einer Dicke von ca. 750 µm und einem oberen Substrat 2 besteht. Das obere Substrat besteht im vorliegenden Fall ebenfalls aus Glas mit einer Dicke von etwa 150 µm, wobei hier auch andere Materialien verwendet werden können, die im Wellenlängenbereich zwischen 250 ... 450 nm eine ausreichende Transparenz aufweisen. Zwischen beiden Substraten 1 und 2 befindet sich ein Strömungskanal 3, der an seinen Enden jeweils mit einem fluidischen Durchkontakt 4 zur Zu- und Ableitung einer Flüssigkeit versehen ist. Der Strömungskanal 3 wird in seiner gesamten Längsausdehnung seitlich durch einen Spacer-I 5 und einen weiteren Spacer-II 6 begrenzt, der sich beidseits außerhalb des Strömungskanales 3 neben dem Spacer-I erstreckt.

Weiterhin befindet sich auf dem oberen Substrat 2 und dem unteren Substrat 1 eine Elektrodenstruktur 7, die über Leitbahnen 8 mit Außenkontakten 9 verbunden ist.

In Gegensatz zu den Leitbahnen 8 auf dem unteren Substrat 1 enden die Leitbahnen 8 auf dem oberen Substrat 2 in Kontaktpads 10, die mittels Leitkleber oder Lötpads bzw. µ-Balls (Mikrolötkugeln) 18 mit den Außenkontakten 9 auf dem unteren Substrat 1 elektrisch verbunden sind.

Ferner sind sämtliche Außenkontakte 9 auf dem unteren Substrat 1 in einem Kontaktsupport 11 zusammengefasst, der die Aufgabe einer zusätzlichen gegenseitigen Isolation hat.

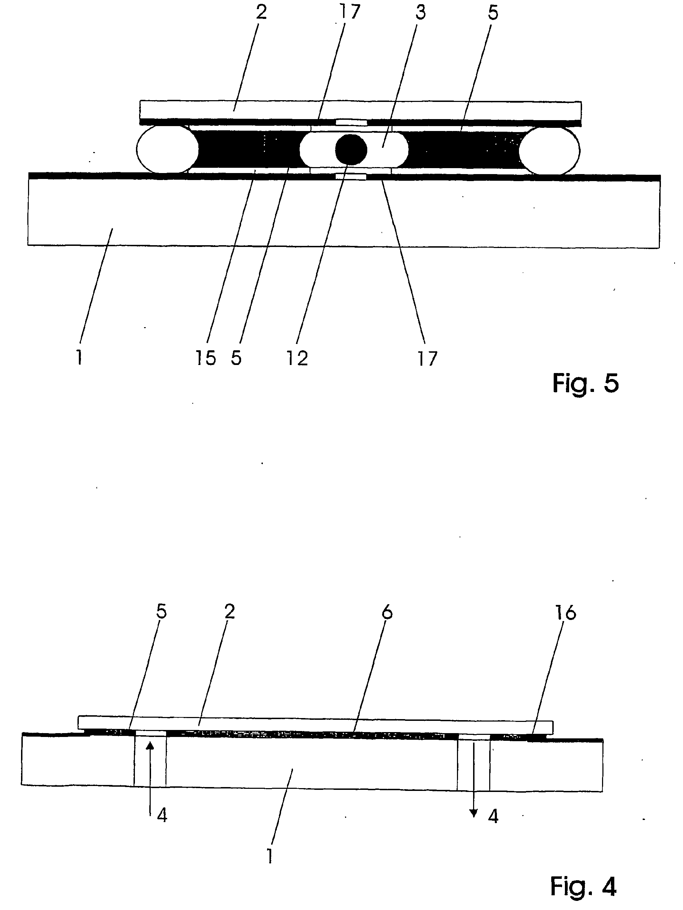

Zur elektrostatischen Fixierung von Zellen 12 bzw. biologischen Partikeln o.dgl. an einem vorgegebenen Ort innerhalb des Strömungskanales 3 (vgl. Fig. 5) enthält die Elektrodenstruktur 7 Mikroelektroden 13, die jeweils auf dem unteren Substrat 1 und dem oberen Substrat 2 in den Strömungskanal hineinragen und dreidimensional exakt positioniert sind.

Zur Erzielung eines über das Substrat konstanten Spacerabstandes zwischen den Substraten 1, 2 sind weiterhin noch Abstandshalter 14 vorgesehen.

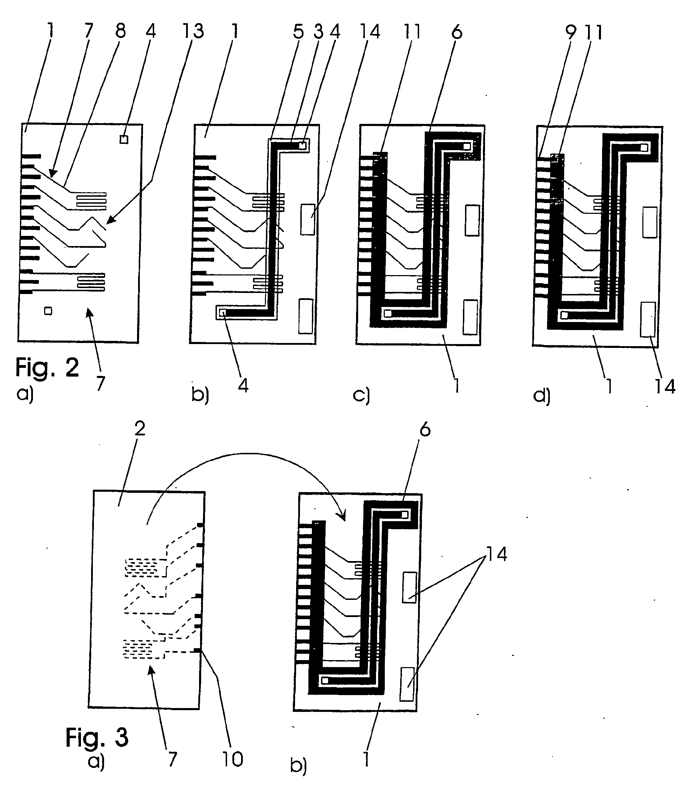

Um die Ausbildung der einzelnen Strukturen auf dem unteren Substrat 1 besser veranschaulichen zu können, zeigt Fig. 2 eine entsprechende Sequenz. Dazu wird das untere Glassubstrat 1 zunächst gebohrt, um später die erforderlichen fluidischen Durchkontakte 4 zum Strömungskanal 3 realisieren zu können. Anschließend wird das untere Substrat 1 mit Hilfe der üblichen Dünnfilmtechnik und Fotolithografie mit der Elektrodenstruktur 7 und den Leitbahnen 8, sowie den Außenkontakten 9 versehen. Die gesamte Struktur wird anschließend ganzflächig mittels eines anorganischen Isolatormaterials 15 isoliert. Dieser Isolator 15 wird anschließend im Bereich des künftigen Strömungskanales 3, sowie an den Außenkontakten 9 wieder entfernt, um wirksame elektrische Strukturen herstellen zu können.

Nachfolgend wird der Strömungskanal 3 auf dem unteren Substrat 1 ausgebildet, indem ein Spacer-I 5 aus einem Polymer auf dem unteren Substrat 1 aufgebracht wird. Selbstverständlich kann der Spacer-I auch zusätzlich auf dem oberen Substrat 2 ausgebildet werden. Für die Herstellung des Spacers-I 5 kann ein hochviskoser positiv Fotoresist, ein negativ Trockenresist oder ein mittels Siebdruck aufgebrachter Polymerfilm genutzt werden. Alle drei Varianten ermöglichen die Herstellung eines Spacers-I 5. Diese drei Varianten ermöglichen die Herstellung eines Spacers-I 5, der eine Dicke im Bereich von 10 µm und 100 µm aufweisen kann. Wichtig ist in jedem Falle, dass mit der Dicke des Spacers-I 5 zugleich die Höhe des Strömungskanales 3 festgelegt wird.

Anschließend wird der Spacer-I 5 durch Wärmeeinwirkung oder UV-Strahlung gehärtet. Ganz wesentlich bei diesem Schritt ist, dass der Spacer-I 5 nach dem Härten genau die Dicke aufweist, die später der Strömungskanal 3 besitzen soll.

Darauf hin wird der Spacer-II 6, den Spacer-I 5 umgebend, auf das untere Substrat 1, durch Drucken oder mit Hilfe eines Dispensers aufgebracht. Die Dicke des Spacers-II 6 ist größer als die des Spacers-I 5. Als Spacer-II 6 wird in jedem Fall ein Kleber auf der Basis von Epoxydharz oder Silikonkautschuk verwendet.

Es ist auch möglich, in der Oberfläche des Spacers-I eine längs desselben verlaufende flache Grube mit Hilfe bekannter fotolithografischer Verfahren auszubilden und in diese den Spacer-II (Kleber) zu dispensen oder zu drucken. Die Tiefe der Grube liegt zwischen 10 - 35 µm.

Das Verkleben des oberen mit dem unteren Substrat 1, 1 erfolgt dann in justierter Lage.

Der Vorteil dieser Variante besteht darin, dass auch Sandwich-Systeme mit deutlich größerer Spacerhöhe über 20 - 50 µm realisiert werden können.

Bei dem oberen Substrat 2 wird entsprechend Fig. 3a lediglich eine Elektrodenstruktur 7 auf gleiche Weise erzeugt wie auf dem unteren Substrat und über Leitbahnen mit Kontaktpads 10 verbunden. Auch diese Struktur wird anschließend mit einem organischen oder anorganischen elektrischen Isolatormaterial 15 ganzflächig isoliert, wobei anschließend die Elektrodenstruktur 7 im Bereich des künftigen Strömungskanales sowie der Kontaktpads 10 durch Entfernen des Isolatormateriales 15 wieder freigelegt werden.

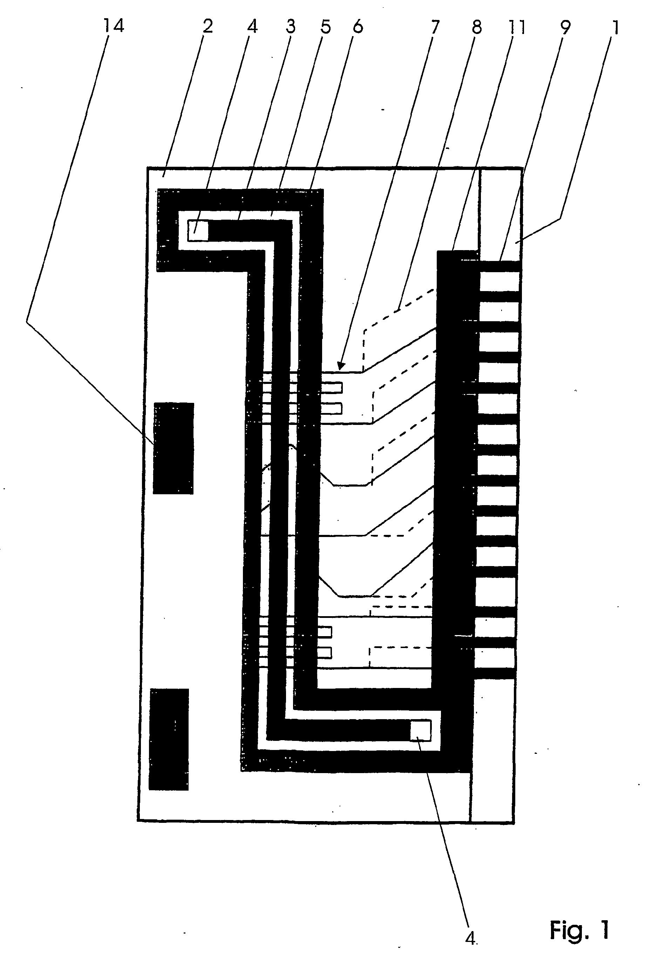

Danach erfolgt die Flip-Chip-Montage entsprechend Fig. 3, indem das obere Substrat 2 Face-down exakt über dem unteren Substrat positioniert und anschließend aufgesetzt wird. Gleichzeitig wird Wärme zugeführt, um den Spacer-II 6 auszuhärten und somit die 3-D-Struktur wie in Fig. 1, 4, 5 dargestellt, herzustellen.

Um die nötigen elektrischen Kontakte zwischen den Kontaktpads 10 auf dem oberen Substrat und den Außenkontakten 9 auf dem unteren Substrat herstellen zu können, wird vor der Flip-Chip-Montage ein geeigneter Leitkleber 16 auf die Anschlüsse dispenst.

Zur Verhinderung des Eindringens von Klebstoff in den Strömungskanal 3 während des Montagevorganges, kann auf der Oberfläche des Spacers-I 5 eine längs desselben verlaufende, z. B. V-förmige Nut oder Grube eingearbeitet sein. Dies ist mittels der bekannten Verfahren der Fotolithografie problemlos möglich. Außerdem wird.dadurch eine höhere Festigkeit der Gesamtstruktur erreicht.

Da schon die Kanalwandungen des Spacers-I 5 beim Beleuchten einer im Strömungskanal 3 räumlich fixierten Zelle 12 während der optischen Detektion eine störende Fluoreszenz erzeugen, muss für die optisch hochauflösende Detektion an z.B. einem Immersionsobjektiv eines Mikroskopes eine geeignete Ausblendung der Eigenfluoreszenz des Spacermateriales erfolgen.

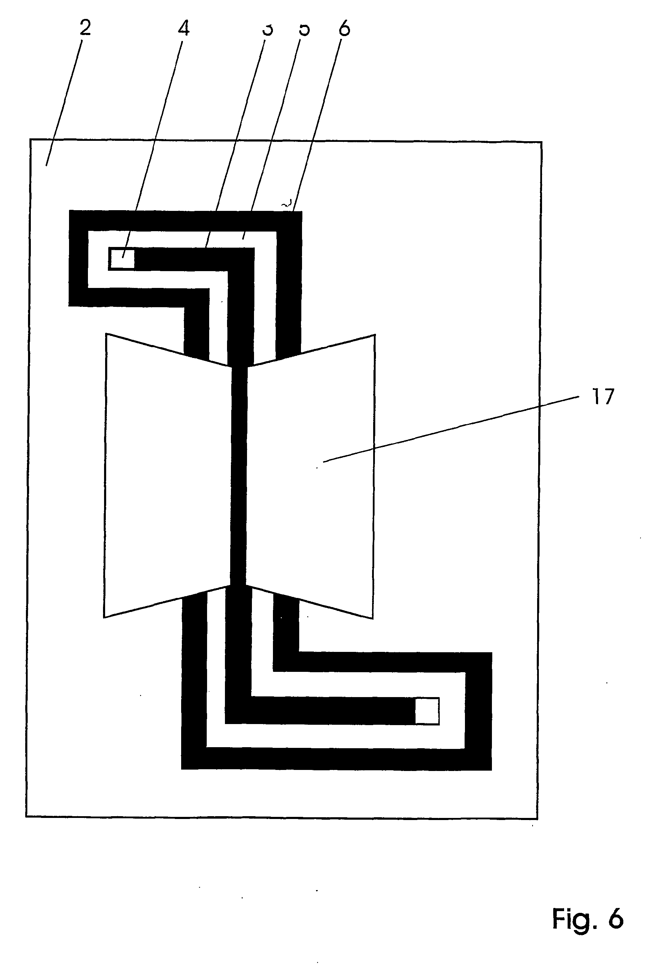

Um derartige Störungen auszuschließen, kann entsprechend Fig. 6 eine lichtundurchlässige Blende 17 vorgesehen werden, die den Rand des Strömungskanales 3 abdeckt und den zentralen Bereich freihält. Diese Blende 17 kann aus einem metallischen strukturierbaren und justierten Dünnfilm hergestellt werden. Um eine solche Blende ggf. reversibel zu gestalten, ist der Gebrauch eines leicht entfernbaren Schichtsystemes sinnvoll, so dass bei Bedarf der gesamte Querschnitt des Strömungskanales 3 beobachtet werden kann.

Der besondere Vorteil einer solchen Blende 17 ist, dass eine floureszenzbasierte Detektion an biologischen Zellen 12 im Strömungskanal 3 erfolgen kann, ohne dass die dabei gleichzeitig veranlasste Fluoreszenz der den Kanal 3 begrenzenden Materialien einen durch Streulicht verursachten störenden Einfluss ausüben würde. Ein weiterer Vorteil ist darin zu sehen, dass es durch die Blende 17 nicht mehr erforderlich ist, im optischen System einen zusätzliche Blende vorzusehen, was zu einer höheren Lichtstärke des optischen Systemes führt.

Die Blende 17 kann vorteilhaft auch als Abschirmung von innen und außen für elektromagnetische und bioelektrische Strahlung ausgebildet sein, wodurch sicher verhindert wird, dass regelmäßig vorhandener Elektrosmog einen negativen Einfluss auf die Detektion der Zellen ausüben kann.

Im einfachsten Fall kann die Blende 17 aus einem Metall gefertigt werden, wobei die Blende 17 auch aus einem fotolithografisch strukturierbaren Dünnfilm, z.B. aus Cu, Al oder einem anderen Metall, bestehen kann.

Damit kann die Blende 17 einfach durch Ätzen ohne Beeinträchtigung der Mikrodurchflusszelle entfernt werden.

Für den Fall, dass lediglich Wert auf eine optische Abschirmung durch die Blende 17 gelegt wird, kann diese natürlich auch aus anderen Materialien, z.B. einem Kunststoff, gefertigt werden.

In besonderen Fällen kann es wünschenswert sein, dass das obere Substrat 1 mit dem unteren Substrat 2 lösbar verbunden ist. Für diesen Fall ist eine besondere Variante der Erfindung dadurch gekennzeichnet, dass der Spacer-II 6 aus Silikongummi auf den Spacer-I 5 aufgedruckt ist und nach dem Ausvulkanisieren das obere und das untere Substrat 2, 1 kraftschlüssig miteinander verbunden werden. Die kraftschlüssige Verbindung kann durch eine einfache Klemmvorrichtung realisiert werden.

Im einfachsten Fall, d.h. wenn das obere Substrat keine Elektrodenstruktur 7 aufweist, kann eine wesentliche Vereinfachung des Aufbaues der 3-D-Mikrodurchflusszelle erreicht werden, wenn der fotolithografisch auf dem unteren Substrat 1 hergestellte Spacer-I 5 eine Breite aufweist, die im wesentlichen der Parallelanordnung von Spacer-I 5 und Spacer-II 6 entspricht (Fig. 5), wobei das obere Substrat 2 lediglich durch Adhäsionskraft auf dem unteren Substrat 1 befestigt ist. Voraussetzung hierfür ist, dass die Kontaktfläche des ersten Spacers-I (5) mit dem oberen Substrat vollkommen eben ist.

### Bezugszeichenliste

- 1: unteres Substrat
- 2: oberes Substrat
- 3: Strömungskanal
- 4: fluidischer Durchkontakt
- 5: Spacer I
- 6: Spacer II
- 7: Elektrodenstruktur
- 8: Leitbahn
- 9: Außenkontakt
- 10: Kontaktpad
- 11: Kontaktsupport
- 12: Zelle
- 13: Mikroelektrode
- 14: Abstandshalter
- 15: Isolator
- 16: Leitkleber
- 17: Blende
- 18: µ-Ball

## Patentansprüche

1. Verfahren zum Herstellen einer 3-D-Mikrodurchflusszelle bestehend aus einem unteren und einem oberen Substrat, zwischen denen ein Strömungskanal angeordnet ist, den eine mit Außenkontakten verbundene Elektrodenstruktur durchdringt, wobei wenigstens eines der Substrate zunächst mit einer Leitbahn- und Elektrodenstruktur und an den Enden des Strömungskanales mit Durchkontaktierungen zum Anschluss von Flüssigkeitszu- und -abläufen versehen wird wobei wenigstens auf dem unteren Substrat (1) den Strömungskanal (3) beidseits desselben definierende Spacer-I (5) sowie zusätzliche Abstandshalter (14) aus einem im wesentlichen nicht kompressiblen Material oder härtbarem Material vorgegebener Höhe aufgebracht werden, die nach dem Aufbringen mit dem unteren bzw. oberen Substrat (1; 2) irreversibel fest verbunden werden, dass außerhalb des Srömungskanales ein pastöser Klebstoff als Spacer-II (6) gleichmäßiger Dicke aufgetragen wird und dass anschließend das obere Substrat (2) auf dem unteren Substrat (1) positioniert und unter Kraft- und Wärmeeinwirkung mit diesem verbunden wird, wobei gleichzeitig der Strömungskanal (3) abgedichtet wird.

2. Verfahren nach Anspruch 1, **dadurch gekennzeichnet, dass** der Spacer-II (6) unmittelbar neben dem Spacer-I (5), diesen parallel umfassend, aufgetragen wird, wobei die Dicke des Spacers-II (6) vor der Montage größer ist, als die Höhe des Spacers-I (5).

3. Verfahren nach Anspruch 1, **dadurch gekennzeichnet, dass** in die Oberfläche des Spacers-I (5) eine längs desselben verlaufende flache Grube eingearbeitet und dass der pastöse Spacer-II (6) in diese Grube dispenst oder gedruckt wird.

4. Verfahren nach Anspruch 3, **dadurch gekennzeichnet, dass** die flache Grube durch fotolithografische Verfahren hergestellt wird.

5. Verfahren nach Anspruch 1 und 2, **dadurch gekennzeichnet, dass** der Spacer-I (5) und die Abstandshalter (14) mittels Siebdruck wenigstens auf das untere Substrat (1) aufgebracht und anschließend gehärtet werden.

6. Verfahren nach Anspruch 4, **dadurch gekennzeichnet, dass** das Härten durch Wärmeeinwirkung und/oder durch Licht-Bestrahlung, wie UV-Bestrahlung, vorgenommen wird.

7. Verfahren nach Anspruch 1, **dadurch gekennzeichnet, dass** Spacer-I (5) und Abstandhalter (14) wenigstens auf dem unteren Substrat (1) mittels fotolithografischer Verfahren, oder durch Dispensieren hergestellt und anschließend durch Tempern gehärtet werden.

8. Verfahren nach Anspruch 7, **dadurch gekennzeichnet, dass** der Spacer-I (5) und die Abstandshalter (14) aus einem fotostrukturierbaren Resist hergestellt werden und die Restdicke die Höhe des Strömungskanales (3) definiert.

9. Verfahren nach Anspruch 1, **dadurch gekennzeichnet, dass** Spacer-I (5) und Abstandshalter (14) aus einer vorstrukturierten, wenigstens einseitig klebenden Metall- oder Polymerfolie hergestellt und wenigstens auf das untere Substrat (1) aufgeklebt werden.

10. Verfahren nach einem der Ansprüche 1 bis 9, **dadurch gekennzeichnet, dass** die Herstellung der Verbindung des oberen Substrates (2) mit dem unteren Substrat unter Einwirkung von Druck und Wärme und/oder UV-Strahlung erfolgt.

11. Verfahren nach einem der Ansprüche 1 bis 10, **dadurch gekennzeichnet, dass** ein Klebstoff als Spacer-II (6) auf der Basis von Epoxydharz oder Silikonkautschuk verwendet wird.

12. 3-D-Mikrodurchflusszelle, hergestellt nach dem Verfahren nach einem der Ansprüche 1 bis 9, bestehend aus einem unteren und einem oberen Substrat, wobei zwischen den Substraten ein mit fluidischen Durchkontakten versehener Strömungskanal angeordnet ist, den ein mit Außenkontakten verbundenes Elektrodensystem durchdringt, wobei wenigstens auf dem unteren Substrat (1) den Strömungskanal (3) definierende Spacer-I (5) sowie zusätzliche Abstandshalter (14) aus einem im wesentlichen nicht kompressiblen Material, oder härtbarem Material, vorgegebener Höhe angeordnet sind, die mit dem unteren bzw. oberen Substrat (1; 2) irreversibel fest verbunden sind, dass das obere Substrat (2) mit dem unteren Substrat (1), den Strömungskanal (3) dicht verschließend, mittels einer pastösen, härtbaren Klebstoffschicht als Spacer-II (6) verbunden ist.

13. 3-D-Mikrodurchflusszelle nach Anspruch 12, **dadurch gekennzeichnet, dass** sich der Spacer-II (6) beidseits außerhalb des Strömungskanales (3) auf der Außenseite der Spacer-I (5) streifenförmig längs desselben erstreckt.

14. 3-D-Mikrodurchflusszelle nach Anspruch 12, **dadurch gekennzeichnet, dass** in der Oberfläche des Spacers-I (5) eine flache Grube zur Aufnahme eines pastösen Spacers-II (6) eingearbeitet ist

15. 3-D-Mikrodurchflusszelle nach Anspruch 12 bis 14, **dadurch gekennzeichnet, dass** die Dicke der Spacer I (5) und der Abstandshalter (14) gleich ist und zwischen - 10 µm und ~ 100 µm liegt.

16. 3-D-Mikrodurchflusszelle nach den Ansprüchen 12 bis 15, **dadurch gekennzeichnet, dass** wenigstens das untere Substrat (1) aus Glas besteht und eine Dicke von - 250 µm ... 1000 µm aufweist.

17. 3-D-Mikrodurchflusszelle nach einem der Ansprüche 10 bis 13, **dadurch gekennzeichnet, dass** das obere Substrat (2) aus einer Kunststoff-Folie besteht.

18. 3-D-Mikrodurchflusszelle nach Anspruch 17, **dadurch gekennzeichnet, dass** das obere Substrat (2) aus einer Polymerfolie mit einer Dicke von 170 ... 200 µm besteht.

19. 3-D-Mikrodurchflusszelle nach den Ansprüchen 12 bis 18, **dadurch gekennzeichnet, dass** der Bereich des Strömungskanales (3) wenigstens im Wellenlängenbereich von 250 bis 450 nm optisch transparent ist

20. 3-D-Mikrodurchflusszelle nach einem der Ansprüche 12 bis 19, **dadurch gekennzeichnet, dass** wenigstens das obere Substrat (2) oder das untere Substrat (1) metallische Mikroelektroden (13) enthält, die in einem vorgegebenen geometrischen Bezug zueinander stehen und dass das obere Substrat (2) Face-down auf dem unteren Substrat (1) montiert ist.

21. 3-D-Mikrodurchflusszelle nach Anspruch 20 , **dadurch gekennzeichnet, dass** die Mikroelektroden (13) des oberen Substrates (2) mit Kontaktpads (10) versehen und mit den Außenkontakten (9) auf dem unteren Substrat (1) durch Leitkleber, Leitgummi oder Lötpads elektrisch verbunden sind.

22. 3-D-Mikrodurchflusszelle nach einem der Ansprüche 12 bis 21, **dadurch gekennzeichnet, dass** die Mikroelektroden (13) aus Platin, Gold, Tantal, Titan, Aluminium oder ITO bestehen.

23. 3-D-Mikrodurchflusszelle nach einem der Ansprüche 12 bis 22, **dadurch gekennzeichnet, dass** das Elektroden- und Anschlusssystem auf dem oberen und dem unteren Substrat (2; 1) mittels eines organischen oder anorganischen elektrischen Isolatormateriales ganzflächig isoliert ist, wobei das Isolatormaterial in Inneren des Strömungskanales, auf den Kontaktpads sowie auf den Kontaktsupports ausgespart ist.

24. 3-D-Mikodurchflusszelle nach einem der Ansprüche 12 bis 232, **dadurch gekennzeichnet, dass** auf der Außenseite des oberen Substrates (2) eine lichtundurchlässige Blende (17) in der Weise aufgebracht ist, dass der Randbereich des Strömungskanales abgedeckt, jedoch dessen zentraler Bereich freigehalten ist.

25. 3-D-Mikrodurchflusszelle nach Anspruch 24, **dadurch gekennzeichnet, dass** die Blende (17) als Abschirmung der suspensierten Zellen vor der Einwirkung elektromagnetischer Wellen ausgebildet ist.

26. 3-D-Mikrodurchflusszelle nach Anspruch 25, **dadurch gekennzeichnet, dass** die Blende (17) aus Metall besteht.

27. 3-D-Mikrodurchflusszelle nach Anspruch 26, **dadurch gekennzeichnet, dass** die Blende (17) aus einem fotolithografisch strukturierbaren Cu- oder Al-Dünnfilm besteht.

28. 3-D-Mikrodurchflusszelle nach einem der Ansprüche 25 bis 27, **dadurch gekennzeichnet, dass** die Blende (17) ablösbar ist.

29. 3-D-Mikrodurchflusszelle nach einem der Ansprüche 12 bis 28, **dadurch gekennzeichnet, dass** in den Spacer-I (5) eine Nut oder anderweitige längs desselben verlaufende Vertiefung zur Aufnahme von Klebstoff eingearbeitet ist.

30. 3-d-Mikrodurchflusszelle nach Anspruch 12, **dadurch gekennzeichnet, dass** der Spacer-I (5) aus einem Fotoresist und der Spacer-II (6) aus einem gedruckten Silikonkautschuk bestehen und nach dem Ausvulkanisieren kraftschlüssig, fluidisch dicht und reversibel miteinander verbunden sind.

31. 3-D-Mikrodurchflusszelle nach Anspruch 12, **dadurch gekennzeichnet, dass** der fotolithografisch auf dem unteren Substrat (1) hergestellte Spacer-I (5) eine Breite aufweist, die im wesentlichen der Parallelanordnung von Spacer-I (5) und Spacer-II (6) entspricht und dass das obere Substrat (2) durch Adhäsionskraft auf dem unteren Substrat (1) befestigt ist.

## Claims

1. Method for producing a 3-D micro flow cell comprising an upper and a lower substrate between which is arranged a flow passage through which passes an electrode structure connected to external contacts, at least one of the substrates first being provided with a conductor and electrode structure and, at the ends of the flow passage, with through-contacts to allow inlets and outlets for fluid to be connected in, wherein there are applied, at least to the lower substrate (1), spacers I (5) which define the flow passage (3) on two sides thereof, and additional spacing-maintainers (14) made of a substantially incompressible or hardenable material of preset height which, after application, is solidly and irreversibly connected to the lower and/or upper substrate (1; 2), and a pasty adhesive is applied, away from the flow passage, as a spacer II (6) of uniform thickness, and the upper substrate (2) is then positioned on the lower substrate (1) and is connected thereto by the action of force and heat, the flow passage (3) being sealed off at the same time.

2. Method according to claim 1, **characterised in that** the spacer II (6) is applied immediately next to the spacer I (5), enclosing the latter in parallel therewith, the thickness of the spacer II (6) being greater, prior to assembly, than the height of the spacer I (5).

3. Method according to claim 1, **characterised in that** a shallow trench extending longitudinally of the spacer I (5) is made in the surface thereof, and **in that** the pasty spacer II (6) is dispensed or printed into this trench.

4. Method according to claim 3, **characterised in that** the shallow trench is produced by photolithographic methods.

5. Method according to claims 1 and 2, **characterised in that** the spacer I (5) and the spacing-maintainers (14) are applied by screen printing at least to the lower substrate (1) and are then hardened.

6. Method according to claim 4 , **characterised in that** the hardening is effected by the action of heat and/or by irradiation with light, such as irradiation with UV light.

7. Method according to claim 1, **characterised in that** the spacer I (5) and the spacing-maintainers (14) are produced, at least on the lower substrate (1), by photolithographic methods or by dispensing and are then hardened by tempering.

8. Method according to claim 7, **characterised in that** the spacer I (5) and the spacing-maintainers (14) are produced from a photo-structured resist, and the residual thickness defines the height of the flow passage (3).

9. Method according to claim 1, **characterised in that** the spacer I (5) and the spacing-maintainers (14) are produced from a pre-structured metal foil or polymer film which is adhesive on at least one side and are adhesive-bonded at least to the lower substrate (1).

10. Method according to one of claims 1 to 9, **characterised in that** the making of the connection of upper substrate (2) to the lower substrate is performed by the action of pressure and heat and/or UV radiation.

11. Method according to one of claims 1 to 10, **characterised in that** an adhesive based on epoxy resin or silicon rubber is used as the spacer II (6).

12. 3-D micro flow cell produced by the method according to one of claims 1 to 9, comprising an upper and a lower substrate, a flow passage which is provided with through-contacts for fluid and through which passes through an electrode system connected to external contacts being arranged between the substrates, wherein spacers I (5) which define the flow passage (3), and additional spacing-maintainers (14) made of a substantially incompressible or hardenable material of preset height which are solidly and irreversibly connected to the lower and/or upper substrate (1; 2), are arranged at least on the lower substrate (1), and the upper substrate (2) is connected to the lower substrate (1) by means of a pasty hardenable, layer of adhesive forming a spacer II (6), in such a way as to close off the flow passage (3) with a seal.

13. 3-D micro flow cell according to claim 12, **characterised in that** the spacer II (6) extends in strip form longitudinally of the spacer I (5) on the outside of the latter and on the outside of the flow passage (3), on both sides of the flow passage.

14. 3-D micro flow cell according to claim 12, **characterised in that** a shallow trench for receiving a pasty spacer II (6) is made in the surface of the spacer I (5).

15. 3-D micro flow cell according to claims 12 to 14, **characterised in that** the thickness of the spacer I (5) and of the spacing-maintainers (14) is the same and is between ~10 µm and -100 µm.

16. 3-D micro flow cell according to claims 12 to 15, **characterised in that** at least the lower substrate (1) is composed of glass and is of a thickness of -250 µm ... 1000 µm.

17. 3-D micro flow cell according to one of claims 10 to 13, **characterised in that** the upper substrate (2) comprises a plastics film.

18. 3-D micro flow cell according to claim 17, **characterised in that** the upper substrate (2) comprises a polymer film of a thickness of 170 ... 200 µm.

19. 3-D micro flow cell according to claims 12 to 18, **characterised in that** the region of the flow passage (3) is optically transparent at least in the wavelength range from 250 to 450 nm.

20. 3-D micro flow cell according to one of claims 12 to 19, **characterised in that** at least the upper substrate (2) or the lower substrate (1) contains metallic micro-electrodes (13) which are in a preset geometrical relationship to one another, and **in that** the upper substrate (2) is fitted to the lower substrate (1) face down.

21. 3-D micro flow cell according to claim 20, **characterised in that** the micro-electrodes (13) of the upper substrate (2) are provided with contact pads (10) and are electrically connected to the external contacts (9) on the upper substrate (1) by conductive adhesive, conductive rubber, or solder pads.

22. 3-D micro flow cell according to one of claims 12 to 21, **characterised in that** the micro-electrodes (13) are composed of platinum, gold, tantalum, titanium, aluminium or ITO.

23. 3-D micro flow cell according to one of claims 12 to 22, **characterised in that** the electrode and connection systems on the upper and the lower substrates (2; 1) are insulated by means of an organic or inorganic electrical insulating material over their whole area, the insulating material being recessed in the interior of the flow passage, on the contact pads and on the contact supports.

24. 3-D micro flow cell according to one of claims 12 to 23, **characterised in that** a mask (17) impermeable to light is applied to the outside of the upper substrate (2) in such a way that the edge region of the flow passage is covered, but its central region is left exposed.

25. 3-D micro flow cell according to claim 24, **characterised in that** the mask (17) takes the form of screening for the suspended cells against the effect of electromagnetic waves.

26. 3-D micro flow cell according to claim 25, **characterised in that** the mask (17) is composed of metal.

27. 3-D micro flow cell according to claim 26, **characterised in that** the mask (17) comprises a thin film of Cu or Al able to be structured photolithographically.

28. 3-D micro flow cell according to one of claims 25 to 27, **characterised in that** the mask (17) is detachable.

29. 3-D micro flow cell according to one of claims 12 to 28, **characterised in that** a groove or a depression of some other kind extending longitudinally of the spacer I (5) is made in the spacer I (5) to receive adhesive.

30. 3-D micro flow cell according to claim 12, **characterised in that** the spacer I (5) is composed of a photo-resist and the spacer II (6) of a printed silicon rubber and after being vulcanised they are reversibly connected together by adhesion with a fluid-tight seal.

31. 3-D micro flow cell according to claim 12, **characterised in that** the spacer I (5) which is produced photolithographically on the lower substrate (1) is of a width which substantially corresponds to the spacer I (5) and spacer II (6) laid out in parallel, and **in that** the upper substrate (2) is fastened to the lower substrate (1) by the force of adhesion.

## Revendications

1. Procédé de fabrication d'une micro-cuve à circulation 3D composée d'un substrat inférieur et d'un substrat supérieur entre lesquels, un canal de circulation traverse une structure d'électrodes reliées à des contacts extérieurs,
au moins l'un des substrats étant tout d'abord muni d'une structure de chemins conducteurs et d'électrodes et aux extrémités du canal de circulation, de contacts traversants pour le branchement d'entrée et de sortie de fluide,
au moins sur le substrat inférieur (1), on réalise, de part et d'autre du canal de circulation (3), des séparateurs-I, (5) qui le définissent, ainsi que des moyens d'écartement (14) supplémentaires en une matière principalement non compressible ou en une matière durcissable, de hauteur prédéfinie qui, après mise en place avec le substrat inférieur ou supérieur (1, 2) sont reliés solidairement de manière irréversible,
à l'extérieur du canal de circulation on applique un séparateur-II (6) sous la forme d'un adhésif pâteux, d'épaisseur régulière, et ensuite on place le substrat supérieur (2) sur le substrat inférieur (1) et on le relie à celui-ci par l'action d'une force et de la chaleur, et en même temps on réalise l'étanchéité du canal de circulation (3).

2. Procédé selon la revendication 1,
**caractérisé en ce que**
le séparateur-II (6) est appliqué directement à côté du séparateur-I (5) en entourant celui-ci suivant un tracé parallèle,
l'épaisseur du séparateur-II (6) étant supérieure avant le montage que la hauteur du séparateur-I (5).

3. Procédé selon la revendication 1,
**caractérisé en ce qu'**
on a usiné dans la surface du séparateur-I (5) un sillon plat, tracé le long de ce dernier et on distribue ou on enfonce le séparateur-II (6) pâteux dans ce sillon.

4. Procédé selon la revendication 3,
**caractérisé en ce que**
le sillon plat est fabriqué par un procédé de photolithogravure.

5. Procédé selon les revendications 1 et 2,
**caractérisé en ce que**
le séparateur-1 (5) et le moyen d'écartement (14) sont réalisés par sérigraphie au moins sur le substrat inférieur (1) et ensuite ils sont durcis.

6. Procédé selon la revendication 4,
**caractérisé en ce qu'**
on effectue le durcissement par action de la chaleur et/ou par un rayonnement lumineux tel qu'un rayonnement par ultraviolets.

7. Procédé selon la revendication 1,
**caractérisé en ce qu'**
on réalise le séparateur-I (5) et le moyen d'écartement (14) au moins sur le substrat inférieur (1) par un procédé de photolithogravure ou par dispersion et ensuite on durcit par trempe.

8. Procédé selon la revendication 7,
**caractérisé en ce qu'**
on fabrique le séparateur-I (5) et le moyen d'écartement (14) à partir d'une photorésist susceptible d'être structurée et l'épaisseur résiduelle définit la hauteur du canal de circulation (3).

9. Procédé selon la revendication 1,
**caractérisé en ce que**
le séparateur-I (5) et le moyen d'écartement (14) sont réalisés à partir d'un fil métallique ou de polymère pré-structuré, adhésif, sur au moins une face et collé au moins sur le substrat inférieur (1).

10. Procédé selon l'une des revendications 1 à 9,
**caractérisé en ce qu'**
on fabrique la liaison du substrat supérieur (2) avec le substrat inférieur sous l'action de la pression et de la chaleur et/ou du rayonnement ultraviolet.

11. Procédé selon l'une des revendications 1 à 10,
**caractérisé en ce qu'**
on utilise un adhésif comme séparateur-II (6) à base de résine époxyde ou de caoutchouc au silicone.

12. Micro-cuve à circulation 3-D, fabriquée selon le procédé de l'une des revendications 1 à 9, composée d'un substrat inférieur et d'un substrat supérieur,
un canal de circulation étant prévu entre les substrats avec des contacts traversants, fluidiques, ce canal traversant un système d'électrodes reliées à des contacts extérieurs,
au moins sur le substrat inférieur (1), se trouve le séparateur-I (5) définissant le canal de circulation (3) ainsi que des moyens d'écartement (14) supplémentaires en une matière pratiquement incompressible ou une matière durcissable, de hauteur prédéfinie, reliés de manière solidaire irréversible avec le substrat inférieur ou le substrat supérieur (1, 2),
le substrat supérieur (2) fermant de manière étanche le canal de circulation (3) avec le substrat intérieur (1), en étant relié par une couche d'adhésif pâteuse, durcissable, constituant le séparateur-II (6).

13. Microcellule à circulation 3-D selon la revendication 12,
**caractérisée en ce que**
le séparateur-II (6) se trouve de part et d'autre à l'extérieur du canal de circulation (3) sur le côté extérieur du séparateur-1 (5), sous la forme d'une bande, le long de celui-ci.

14. Microcellule à circulation 3-D selon la revendication 12,
**caractérisée en ce que**
la surface supérieure du séparateur-I (5) comporte un sillon plat, usiné, pour recevoir un séparateur-II (6), pâteux.

15. Microcellule à circulation 3-D selon les revendications 12 à 14,
**caractérisée en ce que**
l'épaisseur du séparateur-I (5) et des moyens d'écartement (14) est identique et est comprise entre ~ 10 µm et ~ 100 µm.

16. Microcellule à circulation 3-D selon les revendications 12 à 15,
**caractérisée en ce qu'**
au moins le substrat inférieur (1) est en verre et a une épaisseur de l'ordre de ~ 250 µm... 1000 µm.

17. Microcellule à circulation 3-D selon l'une des revendications 10 à 13,
**caractérisée en ce que**
le substrat supérieur (2) est un film de matière plastique.

18. Microcellule à circulation 3-D selon la revendication 17,
**caractérisée en ce que**
le substrat supérieur (2) est un film de polymère d'une épaisseur de 170...200 µm.

19. Microcellule à circulation 3-D selon les revendications 12 à 18,
**caractérisée en ce que**
la zone du canal de circulation (3) est optiquement transparente, au moins dans la plage des longueurs d'ondes comprises entre 250 et 450 nm.

20. Microcellule à circulation 3-D selon les revendications 12 à 19,
**caractérisée en ce qu'**
au moins le substrat supérieur (2) ou le substrat inférieur (11) comportent des microélectrodes métalliques (13) en relation géométrique prédéfinie les unes par rapport aux autres et **en ce que** le substrat supérieur (2) est monté avec sa face tournée vers le bas sur le substrat inférieur (1).

21. Microcellule à circulation 3-D selon la revendication 20,
**caractérisée en ce que**
les microélectrodes (13) du substrat supérieur (2) comportent des pattes de contact (10) et sont reliées électriquement aux contacts extérieurs (9) sur le substrat inférieur (1) par des adhésifs conducteurs, des caoutchoucs conducteurs ou des points de soudure.

22. Microcellule à circulation 3-D selon l'une des revendications 12 à 21,
**caractérisée en ce que**
les microélectrodes (13) sont en platine, or, tantal, titane, aluminium ou ITO.

23. Microcellule à circulation 3-D selon l'une des revendications 12 à 22,
**caractérisée en ce que**
le système d'électrodes et de branchement sur le substrat supérieur et le substrat inférieur (2 ; 1) est isolé sur toute la surface par un matériau isolant électrique, organique ou anorganique, la matière isolante étant dégagée à l'intérieur du canal de circulation, sur les pattes de contact et sur les supports de contact.

24. Microcellule à circulation 3-D selon l'une des revendications 12 à 23,
**caractérisée en ce qu'**
un écran (17) transparent à la lumière est installé sur le côté extérieur du substrat supérieur (2), pour couvrir la zone marginale du canal de circulation en laissant néanmoins libre sa zone centrale.

25. Microcellule à circulation 3-D selon la revendication 24,
**caractérisée en ce que**
l'écran (17) est un blindage pour protéger les cellules en suspension contre l'action d'ondes électromagnétiques.

26. Microcellule à circulation 3-D selon la revendication 25,
**caractérisée en ce que**
l'écran (17) est en métal.

27. Microcellule à circulation 3-D selon la revendication 26,
**caractérisée en ce que**
l'écran (17) est un film mince de Cu ou Al structuré par photolithogravure.

28. Microcellule à circulation 3-D selon les revendications 25 à 27,
**caractérisée en ce que**
l'écran (17) est amovible.

29. Microcellule à circulation 3-D selon l'une des revendications 12 à 28,
**caractérisée en ce qu'**
une rainure ou autre cavité longitudinale sont réalisées dans le séparateur-1 (5) pour recevoir de l'adhésif.

30. Microcellule à circulation 3-D selon la revendication 12,
**caractérisée en ce que**
le séparateur-I (5) est formé d'un photorésist et le séparateur-II (6) est du caoutchouc au silicone, imprimé et ces deux séparateurs sont reliés après vulcanisation, par une liaison par la force, de manière étanche au fluide et de façon réversible.

31. Microcellule à circulation 3-D selon la revendication 12,
**caractérisée en ce que**
le séparateur-I (5) réalisé photolithogravure sur le substrat inférieur (1) a une largeur qui correspond pour l'essentiel à la disposition parallèle du séparateur-I (5) et du séparateur-II (6) et **en ce que** le substrat supérieur (2) est fixé par une force par adhésion sur le substrat inférieur (1).
